# FASCICULE DE BREVET EUROPEEN

(11) **EP 4 383 748 B1**
(45) Date de publication et mention de la délivrance du brevet: **01.01.2025**
(21) Numéro de dépôt: 23211128.6
(22) Date de dépôt: 21.11.2023
(51) Int. Cl.: H04R 1/02, H05K 7/20, H04R 1/24, H04R 5/02, H04R 9/02, H04R 1/40

(54) **EQUIPEMENT COMPORTANT UN CAISSON ACOUSTIQUE DOTE D'AU MOINS UN AMPLIFICATEUR**
AUSRÜSTUNG MIT EINEM AKUSTISCHEN GEHÄUSE MIT MINDESTENS EINEM VERSTÄRKER
EQUIPMENT COMPRISING AN ACOUSTIC BOX PROVIDED WITH AT LEAST ONE AMPLIFIER

(30) Priorité: 06.12.2022 FR 2212833
(43) Date de publication de la demande: 12.06.2024
(73) Titulaire: Sagemcom Broadband SAS, 92270 Bois-Colombes (FR)
(72) Inventeur: CHUSSEAU, Hugo, 92270 BOIS-COLOMBES (FR); NEDELCU, Radu, 92270 BOIS-COLOMBES (FR); FERREIRA, Arnaud, 92270 BOIS-COLOMBES (FR); SUSINI, Dominique, 92270 BOIS-COLOMBES (FR); DELPLACE, Stéphane, 92270 BOIS-COLOMBES (FR)
(74) Mandataire: Cabinet Boettcher

(56) Documents cités:
- WO-A1-2021/136962
- CN-U- 211 406 453
- FR-A1- 3 110 797
- US-A1- 2016 010 846
- US-A1- 2020 100 030

## Description

La présente invention se rapporte au domaine des équipements comportant un boitier contenant un caisson et ayant au moins un premier haut-parleur disposé à l'intérieur du caisson pour diffuser des sons vers l'extérieur du boîtier.

### ARRIERE PLAN DE L'INVENTION

Un tel équipement intègre dans un boitier contenant des cartes électroniques, un caisson ayant des qualités acoustiques particulières, cet équipement étant ainsi particulièrement compact (car le caisson est intégré dans le boitier, ce caisson n'étant pas une enceinte externe au boitier) et de qualité sonore améliorée puisque d'une part les caractéristiques acoustiques offertes par le caisson sont directement présentes dans le boitier et puisque d'autre part le premier haut-parleur reçoit un signal audio qui est directement généré dans le boitier pour le premier haut-parleur qui se trouve aussi dans le boitier.

Toutefois, il a été constaté que la présence de ces éléments dans un même boitier peut induire une chauffe de composants électroniques.

Dans certains cas, par exemple lors d'une écoute à forte puissance, la chauffe de certains composants électroniques peut être préjudiciable à leurs performances.

Pour éviter les inconvénients d'une surchauffe, il est parfois nécessaire de limiter la puissance délivrée au premier haut-parleur ce qui est préjudiciable à l'expérience d'écoute. Les documents US 2016/010846 A1, US 2020/100030 A1 et FR 3 110 797 A1 divulguent chacun un équipement comportant un boîtier dans lequel se trouvent un caisson logeant un haut-parleur, des composants électroniques placée dans le boîtier en dehors du caisson et un dispositif de connexion traversant une paroi du caisson et connecté aux composants électroniques.

### OBJET DE L'INVENTION

Un objet de l'invention est de fournir un équipement comportant un boîtier dans lequel se trouvent un caisson, un premier haut-parleur disposé à l'intérieur du caisson et une carte électronique principale placée dans le boitier, en dehors du caisson, l'équipement permettant de résoudre ou du moins atténuer tout ou partie des inconvénients précités de l'art antérieur.

### RESUME DE L'INVENTION

A cet effet, selon l'invention, il est proposé un équipement comportant un boîtier dans lequel se trouvent :
- un caisson ;
- un premier haut-parleur disposé à l'intérieur du caisson et monté au niveau d'une paroi du caisson, le premier haut-parleur étant agencé pour diffuser des sons vers l'extérieur du boîtier ;
- une carte électronique principale placée dans le boîtier en dehors du caisson et sur laquelle est monté au moins un module d'alimentation agencé pour produire une première tension d'alimentation ;
- un dispositif de connexion traversant la paroi du caisson ;
- une carte électronique secondaire placée à l'intérieur du caisson et sur laquelle est monté au moins un premier amplificateur connecté au premier haut-parleur, la carte électronique secondaire étant connectée électriquement à la carte électronique principale via le dispositif de connexion, de sorte que le premier amplificateur est alimenté par la première tension d'alimentation, caractérisé en ce que le dispositif de connexion comporte une carte intermédiaire portant une première pluralité de conducteurs électriques pour alimenter le premier amplificateur avec la première tension d'alimentation, la carte intermédiaire et les conducteurs électriques de ladite première pluralité de conducteurs électriques passant au travers d'une ouverture formée au travers de la paroi du caisson.

Le caisson de l'équipement selon l'invention est un caisson acoustique contenant au moins un premier haut-parleur, ce caisson étant ainsi destiné à la diffusion de sons du premier haut-parleur vers l'extérieur du caisson et plus particulièrement vers l'extérieur du boîtier de l'équipement.

Grâce à l'invention, le premier amplificateur et le premier haut-parleur sont situés dans le caisson, à l'écart de la carte électronique principale et à l'écart du module d'alimentation qui sont, dans le boîtier, mais à l'extérieur du caisson.

De cette manière, le premier amplificateur est moins soumis aux effets thermiques générés au niveau de la carte électronique principale (le module d'alimentation génère de la chaleur), et réciproquement, la carte électronique principale est moins soumise aux effets thermiques générés au niveau du premier amplificateur.

L'invention permet de minimiser le besoin de limiter le gain d'amplification du premier amplificateur pendant son fonctionnement pour éviter une surchauffe.

De manière corolaire, le besoin de limiter la puissance sonore délivrée par le premier haut-parleur pour éviter une surchauffe est largement minimisé par l'invention.

Par ailleurs, plus la distance entre le premier amplificateur et le premier haut-parleur est importante et plus les perturbations électromagnétiques émises ou reçues le long de la liaison entre le premier amplificateur et le premier haut-parleur sont importantes.

En plaçant le premier amplificateur et le premier haut-parleur dans un même caisson, l'invention permet de minimiser la distance entre le premier amplificateur et le premier haut-parleur ce qui limite le niveau d'interférences électromagnétiques émises ou reçues au niveau de la connexion entre le premier amplificateur connecté et le premier haut-parleur.

### BREVE DESCRIPTION DES DESSINS

D'autres caractéristiques et avantages de l'invention ressortiront clairement de la description qui en est faite ci-après, à titre indicatif et nullement limitatif, en référence aux dessins annexés, dans lesquels :
[Fig. 1] la figure 1 est une vue éclatée de l'équipement selon l'invention ;
[Fig. 2] la figure 2 est une vue en perspective de l'équipement 0 selon l'invention ;
[Fig. 3a] la figure 3a est une vue de dessous du capot 19 du boitier de l'équipement permettant d'illustrer la position des microphones 14a, 14b, 14c, 14d et le dissipateur thermique principale 11 permettant d'évacuer de la chaleur générée au niveau de la carte principale 4 ;
[Fig. 3b] la figure 3b est une vue en perspective de dessous du capot supérieur 19 du boîtier 1 de l'équipement 0 où l'on voit la carte électronique principale 4 et des connectiques 43, 44 montées sur cette carte 4 et permettant de relier l'équipement 0 à des éléments externes à l'équipement ;
[Fig. 3c] la figure 3c est une vue de côté du capot 19 illustré sur la figure 3b où l'on voit des nervures 13 avec des échancrures 13a qui permettent de caler la carte principale 4 par coincement sur une portion arrière du boîtier 1 constituée par une face arrière 18 du capot supérieur 19 ;
[Fig. 4] la figure 4 est une vue en perspective du caisson 2 de l'équipement 0 ;
[Fig. 5a] la figure 5a est une vue en perspective de l'intérieur du caisson 2 avec la carte secondaire 6 qui porte le premier amplificateur 6a (sur cette figure 5a, la pièces 24 formant capot du caisson 2 qui comporte les parois supérieure, droite, gauche, avant et arrière du caisson est ici retirée) ;
[Fig. 5b] la figure 5b est une vue de côté de l'ensemble des pièces illustrées à la figure 5a, cette figure 5b illustrant l'inclinaison typique d'un haut-parleur (ici le frontal 3b) par rapport au plan de fond Px défini par le fond 1f du boîtier 1 ;
[Fig. 6] la figure 6 est une vue de dessus du fond du caisson servant de dissipateur thermique et comportant à cet effet des bossages 2f1, 2f2, 2f3 pour recevoir des matériaux d'échange thermique destiner à établir un transfert thermique par conduction depuis des composants à refroidir vers le fond du caisson, cette figure montre aussi des parois internes 25 au caisson 2 qui définissent chacune des chambres étanches 20a, 20, 20d, 20e recevant chacune un haut-parleur ;
[Fig. 7a] la figure 7a est une vue en perspective de l'équipement 0 coupé suivant un plan P0 (visible sur la figure 5a), l'équipement est illustré sans son capot supérieur 19 pour montrer la connexion électrique entre la carte principale 4 et la carte secondaire 6 via la carte intermédiaire 5 ;
[Fig. 7b] la figure 7b est une vue en perspective de l'équipement 0 coupé suivant un plan P0 (visible sur la figure 5a), l'équipement est illustré sans son capot supérieur et sans la carte principale pour l'assemblage de la carte intermédiaire 5 sur la carte secondaire 6b avant que le caisson ne soit refermé avec la pièce définissant les parois supérieure, droite, gauche, avant et arrière du caisson ;
[Fig. 8] la figure 8 est une vue schématique de l'équipement selon l'invention permettant d'illustrer un mode de réalisation particulier où le caisson 2 comporte un dissipateur thermique 10 disposé contre le fond 2f du caisson 2, cette figure 8 illustre aussi le chemin sonore 26 de diffusion des sons générés par le premier haut-parleur 3a.

### DESCRIPTION DETAILLEE DE L'INVENTION

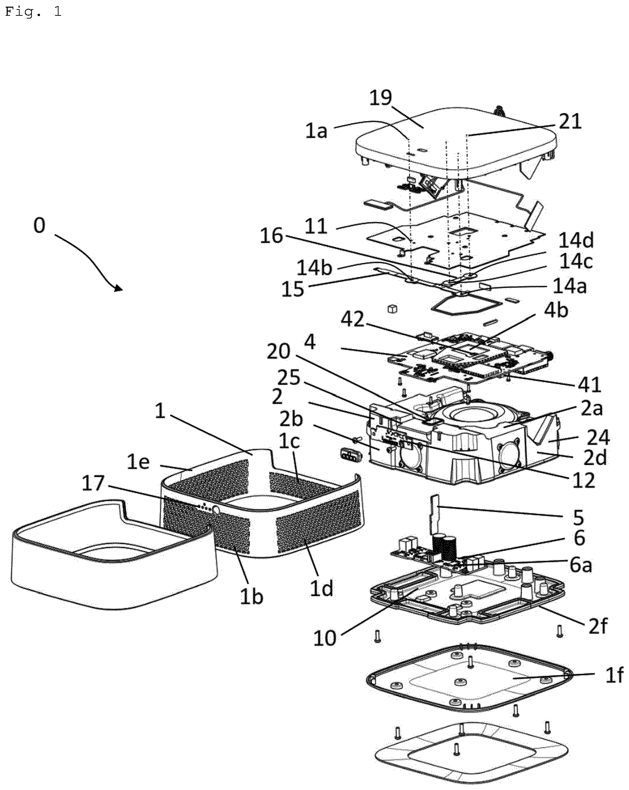

En référence à la figure 1, l'invention concerne principalement un équipement 0 comportant un boîtier 1 dans lequel se trouvent :
- un caisson 2 ;
- un premier haut-parleur 3a disposé à l'intérieur du caisson 2 et monté au niveau d'une paroi 2a du caisson 2, le premier haut-parleur 3a étant agencé pour diffuser des sons vers l'extérieur du boîtier 1 ;
- une carte électronique principale 4 placée dans le boîtier 1 en dehors du caisson 2 et sur laquelle est monté au moins un module d'alimentation 41 agencé pour produire une première tension d'alimentation ;
- un dispositif de connexion 5 traversant la paroi 2a du caisson 2 ;
- une carte électronique secondaire 6 placée à l'intérieur du caisson 2 et sur laquelle est monté au moins un premier amplificateur 6a connecté au premier haut-parleur 3a.

Selon l'invention, la carte électronique secondaire 6 est connectée électriquement à la carte électronique principale 4 via le dispositif de connexion 5 de sorte que le premier amplificateur 6a soit alimenté par la première tension d'alimentation.

Ainsi, l'amplificateur 6a (ainsi que le second amplificateur 6b qui sera présenté par la suite) est placé dans le caisson 2, à distance de la carte électronique principale 4 qui est une « carte chaude » (c'est-à-dire une carte dont les composants ont une émission thermique importante) portant le module d'alimentation 4.

Comme ces amplificateurs 6a, 6b ne sont pas chauffés par la carte principale 4 et sont mieux refroidis, il est dès lors possible de préserver les amplificateurs d'un échauffement dû aux composants présents sur la carte 4 et il est aussi possible d'utiliser des amplificateurs plus puissants sans risquer une surchauffe.

Par exemple, on peut passer d'une tension d'alimentation des amplificateurs de 12V à une tension d'alimentation de 16V de manière à tirer un meilleur parti du premier haut-parleur 3a qui est ici un haut-parleur de graves (typiquement un haut-parleur destiné à reproduire les fréquences inférieures à 1kHz, par exemple les fréquences inférieures à 500Hz).

Comme les amplificateurs sont mieux refroidis et moins impactés par le dégagement thermique des autres composants, il est possible de les faire fonctionner à plus forte puissance et il est par ailleurs possible de choisir des amplificateurs de plus forte puissance mais ayant un moins bon rendement (donc ayant un dégagement thermique plus important pour la même puissance audio restituée).

Ceci peut être utile, par exemple si l'on souhaite changer de références d'amplificateurs ou de composants tout en ayant un risque de surchauffe limité de ces composants.

La carte électronique principale 4 porte au moins un processeur 4b ayant une fonction de décodeur, des mémoires, un module d'alimentation 41 pour générer au moins une première tension d'alimentation et un module audio 42.

Comme on le voit sur les figures 1, 7a, 7b et 8, le dispositif de connexion 5 comporte une carte intermédiaire 5 portant une première pluralité de conducteurs électriques 50 pour alimenter le premier amplificateur 6a avec la première tension d'alimentation.

La carte intermédiaire 5 et les conducteurs électriques 50 passent au travers d'une ouverture 20 formée au travers de la paroi 2a du caisson 2.

Une telle carte intermédiaire 5 (préférentiellement de type circuit imprimé (Printed Circuit Board) est plus avantageuse qu'une nappe de conducteurs électriques, car la carte 5 est rigide et permet d'augmenter la section des conducteurs électriques 50 pour obtenir une meilleure capacité de passage de courant.

De plus, l'assemblage d'une carte intermédiaire 5, « rigide » par rapport à une nappe, est plus facile à réaliser de façon automatisée que l'assemblage d'une nappe « souple », qui nécessite une intervention humaine. La carte électronique principale 4 porte un premier connecteur mécanique 40 et la carte électronique secondaire 6 porte un second connecteur mécanique 60.

La carte intermédiaire 5 :
- porte d'une part un premier connecteur mécanique 51 connecté de manière amovible au premier connecteur mécanique 40 porté par la carte électronique principale 4 ; et
- porte d'autre part un second connecteur mécanique 52 de la carte intermédiaire 5 connecté de manière amovible au second connecteur mécanique 60 porté par la carte électronique secondaire 6 ;
de sorte que la première tension d'alimentation est transmise au premier amplificateur 6a par l'intermédiaire :
- du premier connecteur mécanique 40 porté par la carte électronique principale 4 ;
- des premier et second connecteurs mécaniques 51, 52 portés par la carte intermédiaire 5 ; et par
- le second connecteur mécanique 60 porté par la carte électronique secondaire 6.

Ces connecteurs mécaniques 40, 51, 52, 60 sont électriquement reliés en série.

Ici, les connecteurs 51 et 52 de la carte intermédiaire 5 sont réalisés par de simples pistes électriques formées sur des portions d'extrémités terminales de la carte intermédiaire 5, ces connecteurs 51, 52 étant ici de type mâle.

Bien que ces connecteurs 51 et 52 sont ici de simples pistes, ils pourraient aussi être réalisés avec d'autres types de connecteur plus complexes comportant des pièces supplémentaires avec emboîtements et/ou des détrompeurs.

Chacun des conducteurs électriques 50 de la première pluralité de conducteurs électriques portés par la carte intermédiaire 5 possède :
- une première extrémité propre électriquement reliée au premier connecteur mécanique 51 porté par la carte intermédiaire 5 ; et
- une seconde extrémité propre électriquement reliée au second connecteur mécanique 52 porté par la carte intermédiaire 5.

De cette manière la liaison électrique entre la carte électronique principale 4 et la carte électronique secondaire 6 se fait, de manière réversible, via les connecteurs mécaniques 51, 52 électriquement reliés entre eux via la première pluralité de conducteurs électriques 50.

Comme la carte intermédiaire 5 est rigide, sa connexion sur le second connecteur mécanique 60 porté par la carte secondaire 6 permet de positionner spatialement le premier connecteur mécanique 51 de la carte intermédiaire 5 par rapport à la carte électronique principale 4.

Ainsi, la connexion électrique entre la carte électronique principale 4 et la carte électronique secondaire 6 est particulièrement facile à mettre en oeuvre de manière automatisée.

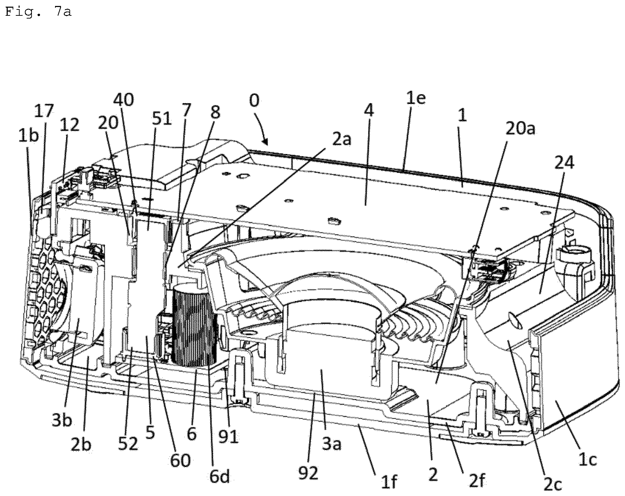

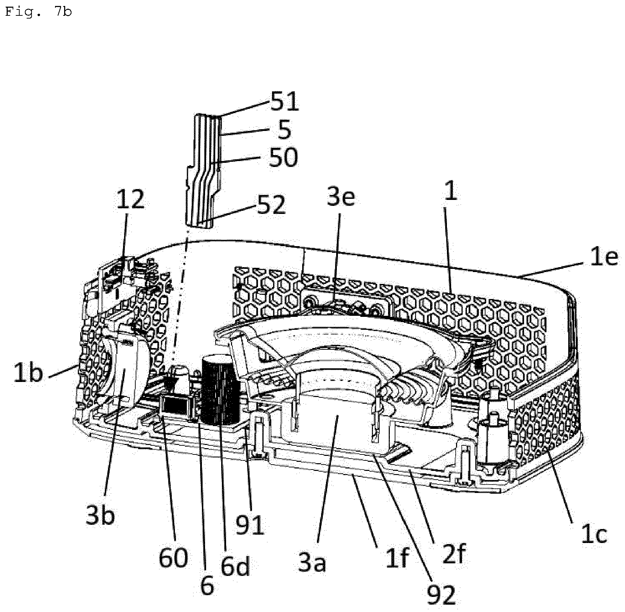

Dans le mode de réalisation préférentiel illustré à la figure 7a, l'un des premiers connecteurs mécaniques 51 est un connecteur de type mâle emboîté dans l'autre desdits premiers connecteurs mécaniques 40 qui est un connecteur de type femelle.

Ces premiers connecteurs mécaniques 40, 51 sont ici connectés entre eux de sorte à présenter un premier jeu autorisant un mouvement relatif entre ces premiers connecteurs mécaniques 40, 51.

De manière similaire, l'un des seconds connecteurs mécaniques 52 est un connecteur de type mâle emboîté dans l'autre desdits seconds connecteurs mécaniques 60 qui est un connecteur de type femelle.

Ces seconds connecteurs mécaniques 52, 60 sont ici connectés entre eux de sorte à présenter un second jeu autorisant un mouvement relatif entre ces seconds connecteurs mécaniques 52, 60.

Ces premier et second jeux entre les connecteurs permettent :
- une meilleure résistance en cas de chute accidentelle de l'équipement ; et
- un assemblage facilité de la carte intermédiaire 5 vis-à-vis des cartes électroniques principale 4 et secondaire 6 (ce qui est favorable à l'automatisation du process d'assemblage).

Préférentiellement, la carte intermédiaire 5 s'étend en longueur et en largeur dans un plan de la carte intermédiaire 5 qui est d'une part perpendiculaire à un plan principal de la carte principale 4 et d'autre part perpendiculaire à une face avant 1b du boîtier 1.

L'orientation à 90° de la carte intermédiaire 5 par rapport à la face avant 1b du boîtier 1 participe à la résistance aux chutes de l'équipement 0.

En effet, en cas de chute de l'équipement, le choc se produit le plus souvent au niveau de la face avant du boîtier, c'est-à-dire suivant le plan de la carte intermédiaire 5 (en cas de chute, les connecteurs et la carte 5 sont généralement préservés).

La carte rigide 5 peut également contribuer à la robustesse de l'équipement en cas de chute, en évitant un éventuel rapprochement des cartes 4 et 6 lors d'un impact.

Préférentiellement, les premier et second connecteurs mécaniques 51, 52 sont identiques entre eux (en l'occurrence il s'agit ici de connecteurs mâles de type PCI express) et les premier et second connecteurs mécaniques 40, 60 respectivement portés par la carte électronique principale 4 et par la carte électronique secondaire 6 sont également identiques entre eux (en l'occurrence il s'agit ici de connecteurs femelles de type PCI express).

Le fait d'avoir des connecteurs mécaniques identiques entre eux permet de réduire le nombre de types de composants nécessaires pour réaliser la connexion électrique entre les cartes.

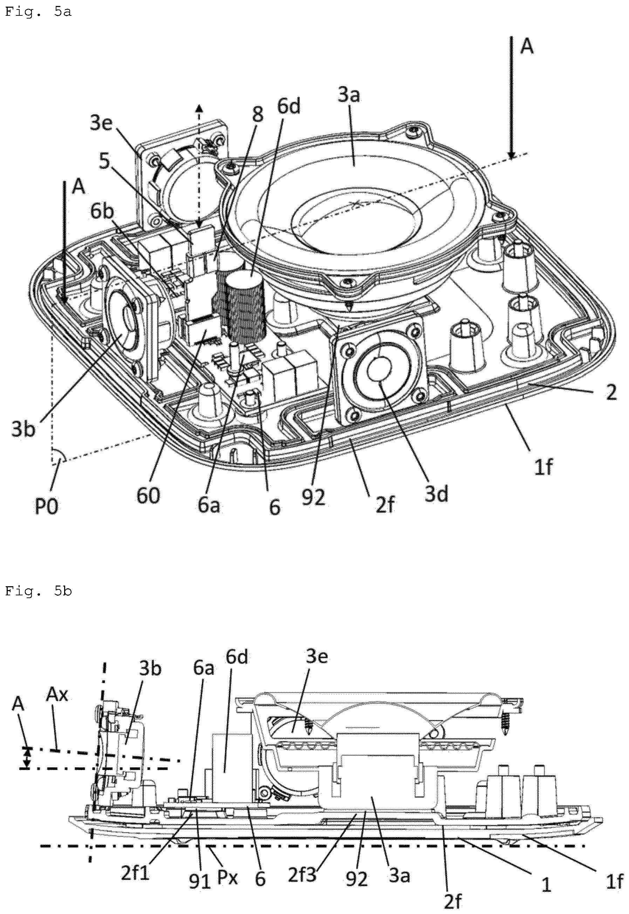

Comme illustré sur les figures 5a, 7a, 7b et 8, la carte intermédiaire 5 est préférentiellement de forme dissymétrique de sorte que la connexion électrique entre la carte électronique principale 4 et la carte électronique secondaire 6 via la première pluralité de conducteurs électrique 50 portés par carte intermédiaire 5 est possible dans une unique position / orientation de la carte intermédiaire 5 par rapport aux cartes électroniques principale 4 et secondaire 6.

La forme dissymétrique de la carte intermédiaire 5 autorise la connexion électrique entre les cartes uniquement lorsque la carte intermédiaire est dans sa position unique.

Cette forme dissymétrique interdit de positionner la carte intermédiaire 5 dans une autre position / autre orientation que ladite position unique visible sur les figures.

Cette forme dissymétrique de la carte intermédiaire 5 permet un détrompage mécanique qui facilite l'assemblage de la carte intermédiaire tout en permettant d'assigner à chaque conducteur électrique 50 une fonction unique dans la connexion électrique entre les cartes principale 4 et secondaire 6.

Ainsi, chaque conducteur électrique 50 peut être spécifiquement développé / dimensionné pour transporter un courant / un signal / une tension donnée qui lui est dédiée.

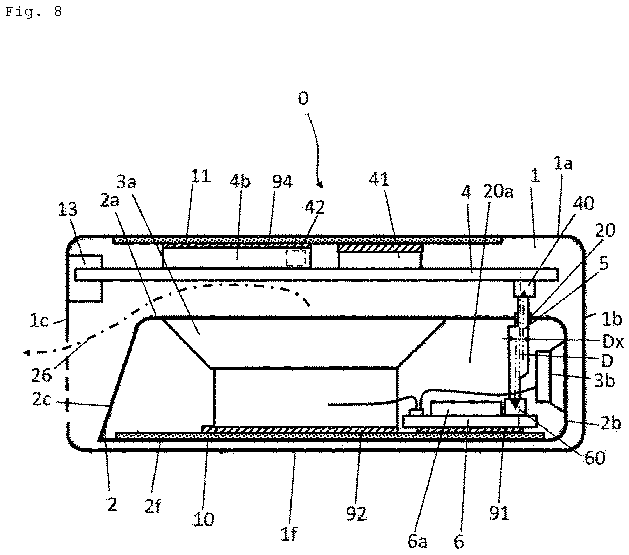

Dans le cas présent, comme illustré sur les figures 1, 5a, 7a, 7b et 8, la dissymétrie de la carte intermédiaire 5 est obtenue par un décalage axial Dx entre des deux extrémités longitudinales de la carte intermédiaire 5 (voir par exemple la figure 8).

La première extrémité longitudinale de la carte intermédiaire 5 est essentiellement d'un côté d'un axe longitudinal D de la carte intermédiaire 5 alors que l'autre extrémité longitudinale de la carte intermédiaire se trouve essentiellement de l'autre côté de l'axe longitudinal D de la carte intermédiaire 5.

Pour augmenter l'aspect dissymétrique de la carte intermédiaire 5 et faciliter la reconnaissance de la position unique dans laquelle elle doit être assemblée, la carte intermédiaire 5 comporte aussi :
- un premier bord longitudinal découpé en escalier et formé le long et d'un premier côté de l'axe longitudinale de la carte intermédiaire ; et
- un second bord longitudinal formé le long et d'un second côté de l'axe longitudinal, ce second bord présentant une portion coupée à 45° par rapport à l'axe longitudinal de la carte intermédiaire.

Comme on le comprend sur les figures 7a et 8, la paroi du caisson est conformée pour buter contre la portion coupée à 45° lorsque la carte intermédiaire 5 se trouve dans une autre position que ladite position unique illustrée sur les figures.

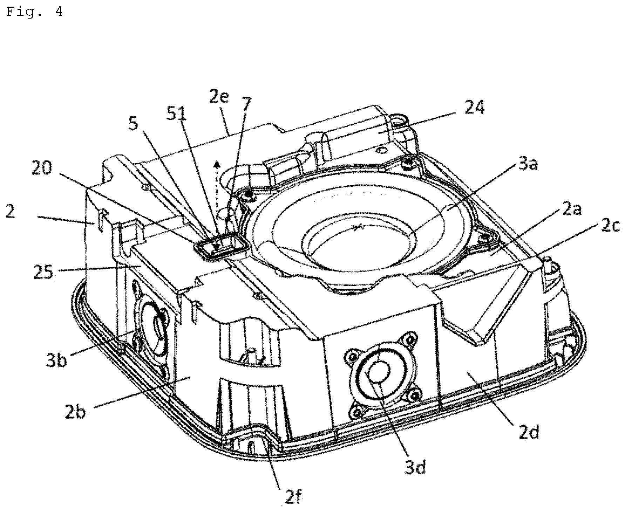

Préférentiellement, un joint compressible 7, visible sur les figures 7a et 4 est disposé pour s'opposer au passage d'air entre l'intérieur et l'extérieur du caisson 2 via l'ouverture 20 formée au travers de la paroi du caisson 2.

Ce joint 7, permet d'assurer une étanchéité acoustique du caisson 2 au niveau de l'ouverture 20 par laquelle passe la carte intermédiaire 5.

Préférentiellement, ce joint 7 est en appui contre la carte électronique principale 4, cette dernière « fermant » ainsi le volume acoustique du caisson 2.

Ce joint 7 est préférentiellement un joint annulaire qui s'étend ici autour du premier connecteur mécanique 40 porté par la carte électronique principale 4.

Ce joint 7 comporte ici des première et seconde faces formées de part et d'autre du joint.

La première face du joint est en appui contre une surface d'appui annulaire portée par la carte électronique principale 4 et la seconde face du joint est en appui contre une surface d'appui annulaire portée par la paroi 2a du caisson 2.

La compression du joint 7 entre la surface d'appui annulaire portée par la carte électronique principale et la surface d'appui annulaire portée par la paroi 2a du caisson permet aussi d'absorber des vibrations / légers déplacements de la carte électronique principale et le caisson 2.

Des vibration parasites peuvent ains être absorbées par le joint 7.

Comme illustré sur la figure 7a, un élément élastiquement déformable 8, préférentiellement en mousse, s'étend tout autour d'une portion longitudinale de la carte intermédiaire 5, à l'intérieur de l'ouverture 20 formée au travers de la paroi 2a du caisson 2.

Cet élément élastiquement déformable 8 permet de s'opposer au contact entre la carte intermédiaire 5 et la paroi du caisson 2.

Ici, l'élément élastiquement déformable 8 (ici un manchon de mousse) entoure une portion longitudinale de la carte intermédiaire 5 pour permettre un alignement de la carte intermédiaire 5 par rapport à l'ouverture 20.

L'assemblage de la carte intermédiaire 5 s'en trouve facilité.

Ce manchon 8 permet ainsi d'absorber / dissiper des vibrations et permet aussi de s'opposer au passage d'air le long de la carte intermédiaire, via l'ouverture 20.

Le module audio 42 est placé dans le boîtier 1, en dehors du caisson 2, et est agencé pour produire un signal audio primaire.

Plus précisément, le module audio 42 est monté sur la carte électronique principale 4 et est alimenté par ledit module d'alimentation 41 via une connexion électrique reliant le module d'alimentation 41 au module audio 42.

Le module audio 42 est aussi connecté à la carte électronique secondaire 6 de sorte que lorsque le signal audio primaire est appliqué en entrée du premier amplificateur 6a et que le premier amplificateur 6a est alimenté par ladite première tension, le premier amplificateur 6a produit, à partir du signal audio primaire, un premier signal audio amplifié à destination du premier haut-parleur 3a.

Les sons diffusés par le premier haut-parleur 3a sont ainsi fonction du premier signal audio amplifié, cette amplification étant réalisée dans le caisson 2, au plus près du premier haut-parleur 3a et à distance de la carte électronique principale 4.

On limite ainsi le risque de perturbation électromagnétique du premier signal audio amplifié ce qui est favorable à la qualité des sons diffusés par l'équipement 0.

Le module audio 42 est électriquement connecté à la carte électronique secondaire 6 par l'intermédiaire du dispositif de connexion 5 de sorte que le signal audio primaire soit transmis du module audio 42 au premier amplificateur 6a par l'intermédiaire du dispositif de connexion 5.

Plus particulièrement, le module audio 42 est électriquement connecté à la carte électronique secondaire 6 par l'intermédiaire de conducteurs électriques audio portés par la carte intermédiaire 5 de sorte à ce que ledit signal audio primaire soit transmis du module audio 42 au premier amplificateur 6a par l'intermédiaire de conducteurs électriques audio spécifiques.

De cette manière, la carte intermédiaire 5 porte des connecteurs électriques dédiés à la transmission de la tension d'alimentation vers le premier amplificateur 6a et des conducteurs électriques audio dédiés à la transmission du signal audio primaire vers le premier amplificateur 6a, limitant ainsi le risque de perturbation de la qualité du signal audio primaire.

Comme illustré sur les différentes figures 1, 4, 5a à 8, l'équipement 0 comporte en outre :
- un haut-parleur droit 3d disposé dans une chambre intérieure droite 20d du caisson 2 ouverte sur une face latérale droite 2d de la paroi du caisson 2 ;
- un haut-parleur gauche 3e disposé dans une chambre intérieure gauche 20e du caisson 2 ouverte sur une face latérale gauche 2e de la paroi du caisson 2 ; et
- un haut-parleur frontal 3b disposé dans une chambre intérieure frontale 20b du caisson 2 ouverte sur une face avant 2b de la paroi du caisson 2.

Le nombre et la disposition de ces haut-parleurs pourrait varier tout en restant dans le cadre de la présente invention.

Ledit premier haut-parleur 3a est ici un haut-parleur de type haut-parleur de graves (les sons graves étant principalement situés entre 20 et 500 Hz) disposé dans une chambre intérieure centrale 20a du caisson 2 disposée entre les chambres intérieures droite et gauche 20d, 20e du caisson 2.

La chambre intérieure centrale 20a est ouverte sur la face supérieure 2a du caisson, en direction de la carte électronique principale 4.

Le boîtier 1 comporte une face arrière 1c qui est ouverte vers l'extérieur du boîtier 1 pour diffuser les sons provenant du premier haut-parleur de grave 3a vers l'extérieur du boîtier.

Le flux d'air généré par les sons du premier haut-parleur 3a contribue ainsi au refroidissement de la carte électronique principale 4.

Les chambres intérieures droites, gauche, frontale et centrale 20a, 20b, 20d, 20e du caisson sont étanches les unes par rapport aux autres.

De cette manière chaque chambre présente un volume interne adapté aux fréquences principales du haut-parleur qu'elle contient.

Par ailleurs, l'étanchéité entre les chambres favorise la séparation des sons générés par les différents haut-parleurs.

Préférentiellement :
- le haut-parleur droit 3d présente un axe sonore principal qui lui est propre et suivant lequel sont majoritairement diffusés les sons qu'il génère ;
- le haut-parleur gauche 3e présente un axe sonore principal qui lui est propre et suivant lequel sont majoritairement diffusés les sons qu'il génère ;
- le haut-parleur frontal 3b présente un axe sonore principal Ax qui lui est propre et suivant lequel sont majoritairement diffusés les sons qu'il génère.

Comme on le comprend des vues en perspective du boîtier 1, 4, 7a et 7b et de la vue en coupe de la figure 5b :
- d'une part le boîtier 1 comporte un fond de boîtier 1f définissant un plan d'appui Px du boîtier (ici le plan Px est défini par des pieds du boîtier destinés à porter l'équipement sur un meuble plan) ; et
- d'autre part l'un au moins desdits axes sonores principaux des haut-parleurs droit, gauche et frontal est orienté par rapport au plan d'appui Px de sorte que le son majoritairement diffusé suivant ledit au moins un axe sonore Ax s'écarte progressivement dudit plan d'appui Px.

Comme cela se comprend de la figure 5b, l'axe sonore principal Ax du haut-parleur frontal 3b s'étend dans un plan perpendiculaire au plan d'appui Px où il forme optionnellement un angle frontal A par rapport au plan d'appui Px.

Cet angle est compris entre 2 et 40° d'angle, par exemple entre 2 et 15° d'angle, préférentiellement il est de 3° d'angle.

De manière similaire, l'axe sonore principal du haut-parleur droit 3d s'étend dans un second plan perpendiculaire au plan d'appui Px où il forme optionnellement un angle latéral droit par rapport au plan d'appui Px qui est compris entre 2 et 50° d'angle, par exemple entre 2 et 15° d'angle, préférentiellement 3° d'angle.

Symétriquement, l'axe sonore principal du haut-parleur gauche 3e s'étend dans ledit second plan perpendiculaire au plan d'appui Px où il forme optionnellement un angle latéral gauche par rapport au plan d'appui Px qui est compris entre 2 et 50° d'angle, par exemple entre 2 et 15° d'angle, préférentiellement 3° d'angle.

Préférentiellement, l'angle latéral droit et l'angle latéral gauche ont une même valeur d'angle.

Avec un axe sonore principal d'un haut-parleur donné formant, dans un plan perpendiculaire au plan d'appui Px, un angle A, par exemple compris entre 2 et 15° par rapport au plan d'appui Px, le son a tendance à être diffusé vers le haut par rapport au plan d'appui Px, c'est-à-dire en s'éloignant progressivement de ce plan d'appui Px.

Comme l'équipement selon l'invention est destiné à être positionné au pied de l'écran de télévision, l'équipement se trouve le plus souvent en position assez basse (entre 50 et 80cm de haut) par rapport à la tête de l'utilisateur observant l'écran de télévision.

Cet angle vertical A positif permet de compenser partiellement la différence de hauteur.

Optionnellement, il est possible d'avoir des angles latéraux significativement supérieurs à l'angle A afin d'améliorer la restitution spatiale des sons émis par les hauts parleurs 3d et 3e (par exemple en tirant parti des réflexions sonores sur les parois et le plafond de la pièce) tout en conservant un chemin sonore direct entre le haut-parleur frontal 3b et l'auditeur.

Optionnellement, les haut-parleurs 3d et 3e présentent un angle entre leur axe sonore principal et le plan d'appui Px, alors que le haut-parleur frontal 3b ne présente pas d'angle entre son axe sonore principal et le plan d'appui Px qui sont parallèles entre eux.

L'angle des haut-parleurs 3d et 3e pourra par exemple être compris entre 15 et 90° (par rapport au plan Px) alors que l'angle du haut-parleur frontal 3b sera par exemple compris entre 0 et 20° (par rapport au plan Px).

Préférentiellement, pour limiter l'apparition de perturbations sonores à l'interface entre les haut-parleurs et le boîtier :
- l'axe sonore principal du haut-parleur frontal est perpendiculaire à la face avant du boîtier ; et/ou
- l'axe sonore principal du haut-parleur droit est perpendiculaire à la face latérale droite du boîtier ou est perpendiculaire à la face supérieure du boîtier ; et/ou
- l'axe sonore principal du haut-parleur gauche est perpendiculaire à la face latérale gauche du boîtier ou est perpendiculaire à la face supérieure du boîtier ; et/ou
- l'axe sonore principal du premier haut-parleur est perpendiculaire à la face supérieure 1a du boîtier définie par un capot supérieur 19 du boîtier.

Préférentiellement :
- la face avant 1b du boîtier 1 présente une pluralité de perforations de diffusion sonore définissant une grille avant en vis-à-vis du haut-parleur frontal 3b ;
- la face latérale droite 1d du boîtier 1 présente une pluralité de perforations de diffusion sonore définissant une grille latérale droite en vis-à-vis du haut-parleur droit 3d ;
- la face latérale gauche 1e du boitier 1 présente une pluralité de perforations de diffusion sonore définissant une grille latérale gauche en vis-à-vis du haut-parleur gauche 3e ; et
- la face arrière 1c du boîtier 1 présente une pluralité de perforations de diffusion sonore définissant une grille arrière pour diffuser des sons générés par le premier haut-parleur 3a (haut-parleur central de type haut-parleur de graves « woofer » dont la membrane est orientée vers la carte électronique principale 4).

Le caisson 2 comporte une face inférieure 2f s'étendant principalement dans un plan de fond de caisson et dans lequel :
- une portion plane de la face latérale droite 2d de la paroi du caisson sur laquelle est fixé le haut-parleur droit 3d forme un angle avec le plan de fond de caisson, mesuré à l'intérieur du caisson, qui est compris entre 50 et 88° d'angle, préférentiellement 77° ;
- une portion plane de la face latérale gauche 2e de la paroi du caisson sur laquelle est fixé le haut-parleur gauche forme un angle avec le plan de fond de caisson, mesuré à l'intérieur du caisson, qui est compris entre 50 et 88° d'angle, préférentiellement 77°.

Comme illustré sur la figure 4, le caisson 2 comporte une face inférieure 2f s'étendant principalement dans un plan de fond de caisson, une portion plane de la face avant 2b de la paroi du caisson sur laquelle est fixé le haut-parleur frontal 3b forme un angle avec le plan de fond 2f, mesuré à l'intérieur du caisson, cet angle étant compris entre 50 et 88° d'angle, préférentiellement de 77°, mais il pourrait aussi être de 90° par exemple dans le cas où l'on ne souhaiterait pas orienter l'axe sonore vers le haut.

Comme on le comprend des figures 4, 5a, 5b et 7a, 7b, les portions planes des faces latérales droite, gauche et de la face avant de la paroi du caisson sur lesquelles sont respectivement fixés les haut-parleurs droit, gauche et frontal sont inclinés par rapport au plan de fond 2f du caisson ce qui permet de simplement obtenir l'inclinaison verticale de chacun des haut-parleurs tout en le rapprochant vers l'intérieur du caisson.

Ce mode de réalisation particulier permet d'obtenir des sons légèrement orientés vers le haut tout en maximisant le volume interne du caisson.

Ce mode de réalisation est particulièrement économique puisqu'il n'impose ni une adaptation sur mesure de chaque haut-parleur donné ni une utilisation d'une pièce de calage inclinée entre le caisson et chaque haut-parleur donné.

Préférentiellement, un second amplificateur 6b est monté la carte électronique secondaire 6 et est connecté à l'un au moins desdits haut-parleurs droit, gauche, frontal, ledit second amplificateur 6b étant relié électriquement audit module d'alimentation 41 via le dispositif de connexion 5 (en l'occurrence via la carte 5), de sorte que le second amplificateur 6b soit alimenté électriquement par le module d'alimentation 41 monté sur la carte électronique principale 4.

L'alimentation électrique du second amplificateur 6b passe par des conducteurs électriques 50 portés par la carte intermédiaire 5 et par chacun desdits connecteurs mécaniques 40, 51, 52, 60.

Le module audio 42 est préférentiellement agencé pour produire un signal audio secondaire.

Ce module audio 42 est connecté à la carte électronique secondaire 6 de sorte que lorsque le signal audio secondaire est appliqué en entrée du second amplificateur 6b et que le second amplificateur est alimenté électriquement par le module d'alimentation 41, le second amplificateur 6b produit alors, à partir du signal audio secondaire, un second signal audio amplifié à destination de l'un au moins desdits haut-parleurs droit, gauche et frontal.

Pour faire face à des appels de puissance ponctuels de l'un et/ou l'autre des amplificateurs 6a, 6b, la carte secondaire 6 porte au moins un condensateur de réserve d'énergie 6d (aussi appelé condensateur de puissance) alimenté électriquement par le module d'alimentation 41 via le dispositif de connexion 5 traversant la paroi 2a du caisson 2.

Ledit au moins un condensateur 6d est par ailleurs électriquement relié audit au moins un premier amplificateur 6a de manière à fournir de l'énergie audit au moins un premier amplificateur et éventuellement au second amplificateur.

Dans le mode de réalisation de l'invention où la carte secondaire porte deux amplificateurs 6a, 6b, il est préférable d'avoir un condensateur par amplificateur pour éviter qu'un appel de puissance ponctuel par le premier amplificateur 6a dédié au haut-parleur de graves 3a n'interfère sur le fonctionnement du second amplificateur 6b qui alimente les autres haut-parleurs.

Ainsi, l'équipement 0 comporte au moins un autre condensateur de réserve d'énergie également monté sur la carte secondaire 6 et alimenté électriquement par le module d'alimentation via le dispositif de connexion.

Cet autre condensateur de réserve peut être électriquement relié à l'un au moins desdits premier et/ou second amplificateurs 6a, 6b pour fournir de l'énergie à ces amplificateurs.

Chacun des condensateurs de réserve d'énergie monté sur la carte secondaire permet de stocker de l'énergie électrique provenant du module d'alimentation 41 porté par la carte électronique principale et, en cas d'appel de puissance électrique par l'un au moins des amplificateurs, de fournir ponctuellement une énergie directement disponible, dans le caisson, au niveau de la carte secondaire 6, au plus près des amplificateurs et des haut-parleurs.

Le fait d'avoir un ou plusieurs condensateurs de réserve montés sur la carte secondaire 6, permet de raccourcir le chemin électrique entre condensateur de réserve et amplificateur(s) ce qui
- limite les appels de puissance au niveau du module d'alimentation (le module d'alimentation 41 peut être ainsi moins fortement dimensionné) ;
- limite la perte d'énergie entre le condensateur et l'amplificateur ;
- améliore le temps de réponse à l'appel de puissance ; et
- limite les interférences électromagnétiques, en particulier lors de la transmission de la charge / puissance vers le ou les amplificateurs.

En d'autres termes, les condensateurs de réserve 6d sont des capacités disposées au plus près des amplificateurs pour répondre à une importante consommation en crête, lors des appels de courant par les amplificateurs.

Ces condensateurs / capacités sont fortement dimensionnées (par exemple 2*2200uF au lieu de 2*400uF nécessaires en régime « stable »), afin de réduire les appels de courant sur ledit au moins un module d'alimentation 41.

En plus de permettre de réduire le coût du module d'alimentation qui peut être moins fortement dimensionné, ceci a un effet bénéfique sur la réduction des interférences électromagnétiques CEM.

Un autre effet de la proximité entre condensateur(s) et amplificateur(s) est la diminution des chutes de tension dues aux pertes résistives sur le chemin d'alimentation, donc une amélioration de la dynamique audio (puissance de crête : peak power).

L'équipement 0 selon l'invention constitue principalement une « Set Top Box » (littéralement « boîte de dessus de poste ») destinée à recevoir des signaux externes contenant des composantes audio et vidéo, à décoder ces signaux et diffuser la composante audio via les haut-parleurs contenus dans le caisson et la composante vidéo via des moyens d'affichage externes à l'équipement.

A cette fin, l'équipement 0 comporte un décodeur placé dans le boîtier 1, en dehors du caisson 2, monté sur la carte électronique principale 4 ou sur une autre carte électronique distante de la carte principale 4, ce décodeur étant éventuellement intégré dans un composant regroupant plusieurs fonctions (par exemple un composant de type « SoC - System on Chip »).

Ce décodeur dispose :
- d'au moins une connectique d'entrée 43 pour recevoir un signal externe à l'équipement comportant une composante vidéo et une composante audio ; et
- d'au moins une connectique de sortie 44 pour diffuser un signal de sortie généré par le décodeur en fonction dudit signal externe, le signal de sortie ayant au moins une composante vidéo.

Ladite au moins une connectique d'entrée 43 est par exemple une entrée optique pour recevoir un signal optique, transmis via une fibre optique et provenant d'un serveur internet et/ou une entrée de type Ethernet / RJ45 pour recevoir un signal électrique provenant d'un serveur internet et/ou une entrée coaxiale pour recevoir un signal électrique provenant d'un récepteur satellite.

La connectique de sortie 44 du signal vidéo est par exemple une sortie HDMI pouvant être reliée à un dispositif externe d'affichage comme une télévision ou un vidéo projecteur au tout autre type de connectique adaptée à diffuser un flux vidéo.

Le décodeur est connecté au module audio 42 et est agencé pour :
- générer, en fonction dudit signal externe reçu par le décodeur, un signal décodé comprenant au moins une composante audio ; et pour
- transmettre le signal décodé audit module audio 42.

Le module audio 42 est agencé pour générer ledit signal audio primaire en fonction du signal décodé.

Il est à noter que le décodage audio et l'application des traitements audio (fonctions de traitement audio faites par le module audio 42) peuvent être réalisés par un même composant électronique (typiquement un DSP) ou par plusieurs composants électroniques séparés.

Le module audio 42 peut être ou non intégré au processeur principal 4b (ici un SoC).

En d'autres termes, les fonctions réalisées par le décodeur et le module audio 42 peuvent être selon le cas réalisées sur un même composant électronique ou être réparties sur plusieurs composants électroniques distincts les uns des autres.

Les connectiques d'entrée et de sortie 43, 44 du décodeur sont chacune accessible depuis l'extérieur du boîtier 1 via des ouvertures de connexion pratiquées au travers de la paroi du boitier 1.

Plus particulièrement, chaque connectique d'entrée ou de sortie 43, 44 est fixée sur un bord arrière de la carte électronique principale 4 et les ouvertures de connexion sont formées au travers de la portion arrière 18 du capot supérieur 19 du boitier 1.

Grâce à ces caractéristiques, l'assemblage de l'équipement selon l'invention est grandement facilité.

En une seule étape de fixation de la carte électronique principale 4 dans le boitier 1, on positionne également les connectiques d'entrée 43 et de sortie 44 par rapport au boitier 1.

En une seule étape de positionnant du capot 19 de boitier 1 sur le reste du boitier 1, on réalise :
- le calage de la carte principale 4 par rapport au capot 19 (grâce aux nervures 13 échancrées qui limitent le risque de vibrations entre la carte 4 et le boitier 1) ; et
- le positionnement de chaque connectique 43, 44 face à l'ouverture de connexion qui lui correspond (les ouvertures de connexion sont ici pratiquées dans la portion arrière 19 du capot 19).

Les aspects de dissipation thermique vont maintenant être détaillés en référence aux figures 13a5a, 5b, 6, 7a, 7b et 8.

Préférentiellement, l'équipement 0 comporte au moins un premier bloc de matériau échangeur thermique 91 qui est :
- d'un côté en contact contre une face inférieure de la carte électronique secondaire 6 ; et
- d'un autre côté en contact contre une face supérieure d'un dissipateur thermique 10 fixé au caisson 2 pour évacuer de la chaleur générée au niveau de la carte électronique secondaire 6 vers l'extérieur du caisson 2.

Ce dissipateur thermique 10 est ici un fond 2f du caisson 2.

La face supérieure de ce dissipateur thermique 10 comporte au moins un bossage 2f1 localisé qui est en contact contre le premier bloc de matériau échangeur thermique 91.

Ce bossage 2f1, parfois appelé décaissé, permet de rapprocher le fond 1f du caisson 2 au plus près de zone de la carte électronique secondaire 6 dont on veut évacuer de la chaleur.

Un deuxième bloc de matériau échangeur thermique 92 est :
- d'un côté en contact contre une face inférieure du premier haut-parleur 3a (en l'occurrence la face inférieure de l'aimant permanent du haut-parleur) ; et
- d'un autre côté en contact contre la face supérieure du dissipateur thermique 10 fixé au caisson 2 pour évacuer de la chaleur générée par le premier haut-parleur 3a vers l'extérieur du caisson 2.

Le dissipateur thermique 10 fixé au caisson 2 est agencé pour évacuer de la chaleur de l'intérieur vers l'extérieur du caisson 2.

Le deuxième bloc de matériau échangeur thermique 92, outre sa fonction de transmission de chaleur du premier haut-parleur 3a vers le dissipateur thermique 10 permet aussi d'améliorer la rigidité de l'assemblage entre le premier haut-parleur 3a et le caisson 2.

Ceci est utile pour les modèles de haut-parleurs ayant un châssis, aussi appelé « saladier », trop souple / déformable.

Le châssis / saladier du haut-parleur 3a forme une collerette annulaire allant en s'évasant depuis un premier bord de collerette qui est attaché à un aimant permanent jusqu'à un second bord de collerettes sur lequel est attachée une membrane du haut-parleur 3a.

Il a été remarqué que les performances du haut-parleur sont généralement dégradées à partir de 60°C ou 80°C, des distorsions sonores pouvant alors apparaître.

A plus forte température, on peut même observer une dégradation définitive du haut-parleur par perte de caractéristiques magnétiques de son aimant permanent.

Le bon refroidissement des composants / du premier haut-parleur disposés dans le caisson 2 permet de conserver une qualité audio optimale, même à forte puissance sonore, tout en préservant les composants électroniques.

La durée de vie de l'équipement 0 est ainsi améliorée.

Chaque bloc de matériau échangeur thermique 91, 92 a préférentiellement la forme d'un tapis (PAD) mais il peut aussi être réalisé par une pâte thermique moulée au moment du montage contre le dissipateur thermique fixé au caisson.

Le dissipateur thermique 10 fixé au caisson 2 peut être constitué par le fond 2f du caisson 2 ou par une plaque assemblée sur le fond du caisson.

Selon la quantité de chaleur à évacuer et la dimension du dissipateur thermique 10 fixé au caisson, ce dissipateur peut être en matériau polymère, en métal (par exemple en aluminium, ou en cuivre) ou toute combinaison de ces matériaux.

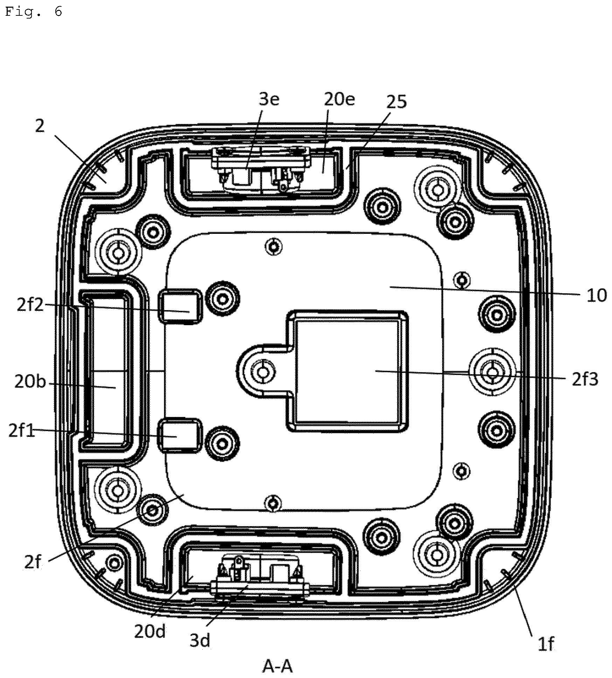

Comme illustré sur la figure 6, le fond 2f du caisson 2 comporte préférentiellement plusieurs bossages 2f1, 2f2, 2f3 (aussi appelés décaissés) chacun disposés pour être en vis-à-vis d'un des blocs de matériau échangeur thermique 91, 92 qui lui correspond et qui est disposé dans le caisson 2.

Chaque bossage 2f1, 2f2, 2f3 est formé pour rapprocher localement le fond du caisson vis-à-vis d'un bloc de matériau échangeur thermique 91, 92 qui lui correspond.

De cette manière le flux thermique au travers du fond du caisson est localisé et optimisé à l'endroit des bossages.

Dans le mode de réalisation illustré par la figure 6, le fond 2f comporte trois bossages / décaissés 2f1, 2f2, 2f3, l'un étant en vis-à-vis d'une face inférieure du premier haut-parleur 3a et les deux autres étant en vis-à-vis d'une face inférieure de la carte électronique secondaires 6 (l'un au niveau de l'implantation du premier amplificateur 6a et l'autre au niveau de l'implantation du second amplificateur 6b monté sur la carte électronique secondaire 6).

Enfin, au moins un troisième bloc de matériau échangeur thermique 94 est :
- d'un côté en contact contre une face supérieure d'au moins un composant électronique porté par la carte électronique principale 4 (en l'occurrence contre le processeur 4b) ; et
- d'un autre côté en contact contre une face inférieure d'un dissipateur thermique principal 11 s'étendant entre la carte électronique principale 4 et le capot supérieur 19 du boîtier 1 pour évacuer de la chaleur générée au niveau de la carte électronique principale 4 vers l'extérieur du boîtier 1.

Selon un autre aspect, l'équipement est également équipé de microphones qui sont par exemple utiles pour capter des sons dans l'environnement de l'équipement pour générer une image spatiale sonore utile pour paramétrer le fonctionnement des haut-parleurs et/ou pour capter des commandes émises par un utilisateur (l'équipement pouvant avoir une reconnaissance vocale et une fonction d'assistant vocal).

Pour cela, l'équipement comporte une pluralité de microphones 14a, 14b, 14c, 14d disposée à l'intérieur du boîtier et connectée à la carte électronique principale 4 par l'intermédiaire d'une unique connectique microphone pour :
- d'une part alimenter électriquement cette pluralité de microphones ; et pour
- d'autre part transmettre à un module microphone porté par la carte électronique principale 4 des signaux micro représentatifs de sons captés par les microphones.

Une première paire des microphones 14a, 14b est montée sur une même première nappe de conducteurs électriques 15 et une seconde paire des microphones 14c, 14d est montée sur une même seconde nappe de conducteurs électriques 16.

La seconde nappe 16 est reliée électriquement à ladite première nappe 15.

La première nappe 15 s'étend suivant un axe de première nappe et la seconde nappe s'étendant suivant un axe de seconde nappe 16 qui est orienté à 90° par rapport à l'axe de première nappe.

De cette manière, la pluralité de microphones 14a, 14b, 14, 14d est reliée à la carte électronique principale 4 via une unique connectique microphone ce qui est particulièrement économique (simplification de l'assemblage).

La connectique microphone est sur la face inférieure de la carte principale 4 est n'est pas visible sur les figures.

Par ailleurs, grâces aux première et seconde nappes 15, 16 disposées à 90° l'une par rapport à l'autre, on positionne spatialement la première paire de microphones 14a, 14b par rapport à la seconde paire de microphones 14c, 14d.

La précision de positionnement spatial des microphones permet une captation précise des sons émis dans l'environnement autour du boîtier 1.

Les microphones de la première paire de microphones 14a, 14b permettent de capter et différentier des sons provenant de la droite ou de la gauche du boîtier alors que les microphones de la seconde paire de microphones 14c, 14d permettent de capter et différentier des sons provenant de l'avant ou de l'arrière du boîtier.

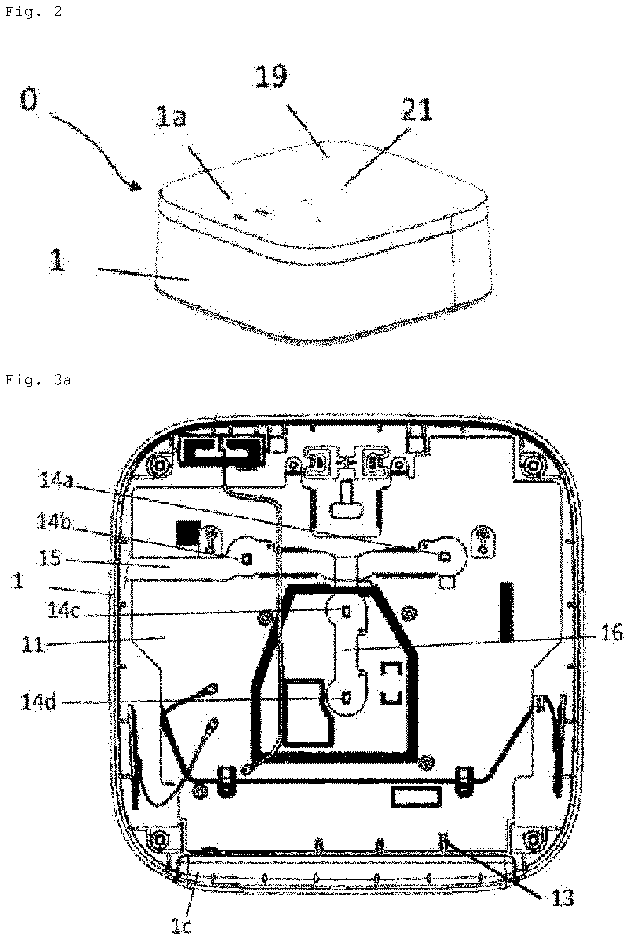

Dans le cas présent, comme illustré sur la figure 3a, les première et seconde nappes 15, 16 qui portent les deux paires de microphones sont montées sur le dissipateur thermique principal 11 (présenté ci-avant) et qui permet d'évacuer de la chaleur de la carte électronique principale 4.

De cette manière, les microphones sont placés plus près du capot supérieur 19 de l'équipement ce qui favorise la qualité de captation sonore.

Chaque microphone est préférentiellement placé au-dessus de l'échangeur thermique principal 11, c'est-à-dire entre l'échangeur thermique principal 11 et le capot 1a du boîtier 1.

Par ailleurs, pour réaliser la captation sonore, chaque microphone est placé face à une perforation 21 qui lui correspond et qui traverse le capot 19.

Préférentiellement, la seconde nappe 16 est reliée de manière amovible à la première nappe 15 éventuellement via un connecteur.

Alternativement, la seconde nappe 16 est reliée à la première nappe 15 par une liaison fixe, par exemple par soudure.

De cette manière, la seconde nappe 16 et les microphones qu'elle porte peut-être optionnelle selon que l'on veut une déclinaison de l'équipement 0 comportant uniquement une première paire de microphones 14a, 14b ou une déclinaison comportant deux paires de microphones 14a, 14b, 14c, 14d.

Ce mode de réalisation avec deux déclinaisons possibles de l'équipement est particulièrement économique à mettre en oeuvre.

Préférentiellement, les microphones de la première paire de microphones sont espacés l'un de l'autre d'au moins 50 mm, préférentiellement de 70mm.

Il peut en être de même pour les microphones de la seconde paire de microphones.

Comme on le voit sur les figures 1 et 7a, l'équipement comporte aussi une carte électronique de communication 12 placée dans le boîtier 1 en dehors du caisson 2.

Cette carte de communication 12 est connectée électriquement à la carte électronique principale 4 via un dispositif secondaire de connexion (ici une nappe déformable non représentée et comportant une pluralité de conducteurs électriques déformables), de sorte à alimenter électriquement au moins un élément électronique de communication monté sur la carte de communication 12.

Ledit au moins un élément électronique de communication appartient au groupe d'éléments électroniques de communication comportant :
- au moins une LED pour diffuser des signaux lumineux via au moins un premier passage optique formé au travers de la paroi du boîtier ; et/ou
- optionnellement au moins un récepteur infrarouge pour recevoir des signaux en infrarouge d'une télécommande de l'équipement, le récepteur infrarouge étant positionné face à au moins un deuxième passage optique formé au travers de la partie avant de la paroi du boîtier ; et/ou
- optionnellement au moins une caméra pour générer des images d'objets se trouvant à l'extérieur du boîtier, ladite au moins une caméra étant positionnée face à un troisième passage optique formé au travers de la partie avant de la paroi du boîtier.

Le fait d'avoir une carte de communication 12 distincte et déportée vis-à-vis de la carte électronique principale 4 permet de limiter la chauffe dudit au moins un élément électronique de communication monté sur la carte de communication 12.

La durée de vie/vieillissement de ces éléments électroniques de communication est ainsi améliorée car ils sont moins impactés par les dégagements thermiques de la carte principale 4 (« carte chaude »).

De plus le refroidissement de la carte électronique de communication 12 (« carte froide ») s'en trouve amélioré.

Le montage des éléments de communication sur une carte électronique dédiée et distincte de la carte électronique principale permet aussi de varier aisément le positionnement spatial / la hauteur de chacun des éléments électroniques de communication (LEDs, récepteur infrarouge et éventuelle caméra) par rapport à la face avant du boîtier.

En effet, comme ces éléments électroniques de communication ne sont pas assujettis sur la carte électronique principale 4, ils peuvent être positionnés en différents emplacements dans le boîtier 1 sans avoir à déplacer ou adapter la carte électronique principale 4.

Dans le mode de réalisation illustré sur les figures 1 à 7b, il est prévu que la carte de communication 12 soit montée dans un renfoncement 25 de la paroi externe du caisson 2 et contre une zone externe de la paroi du caisson.

Ceci permet un gain de place à l'intérieur du boîtier tout en positionnant précisément chaque élément électronique de communication porté par la carte de communication vis-à-vis de la partie avant de la paroi du boîtier qui présente des passages optiques.

Dans le cas présent, comme cela se comprend de la coupe de la figure 7a, chaque passage optique 17 correspond à un seul des éléments électroniques de communication et intègre une lentille optique formant un guide de flux optique au travers de la paroi avant 1b du boîtier.

Préférentiellement, la carte électronique de communication 12 s'étend dans un plan perpendiculaire au plan principal de la carte électronique principale 4 et les éléments électroniques de communication sont montés sur une face principale plane de la carte électronique de communication 12 ce qui facilite le positionnement et l'assemblage de ces éléments électroniques.

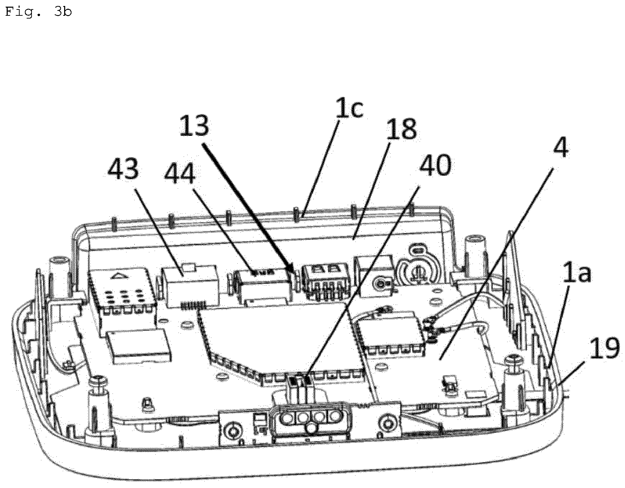

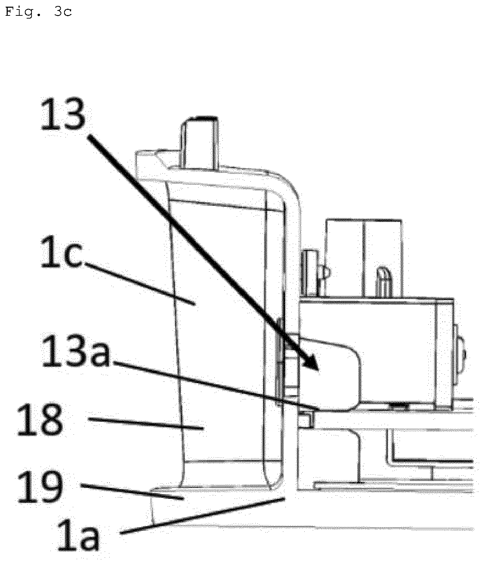

Comme illustré sur les figures 3a, 3b, 3c, des nervures 13 supportées par une face arrière 1c du boitier 1 s'étendent à l'intérieur du boitier 1, ces nervures 13 comportant chacune au moins une échancrure 13a.

Un bord arrière de la carte électronique principale pénètre à l'intérieur de ces échancrures de sorte à caler la carte électronique principale par coincement de son bord arrière dans ces échancrures 13a.

Le coincement du bord arrière de la carte 4 dans les échancrures 13a des nervures 13 permet de limiter le risque d'avoir des vibrations de la carte principale 4 par rapport au boitier 1 limitant d'autant les perturbations sonores.

Il est également possible qu'une mousse élastiquement compressible soit disposée entre le bord arrière de la carte électronique principale et certaines au moins des échancrures 13a ou le fond du boitier de manière à simplifier l'ajustement de la carte principale dans les nervures 13 tout en permettant de dissiper des vibrations dans la mousse.

Plus particulièrement, la face arrière 1c du boitier 1 est ici en partie constituée par une portion arrière 18 du capot supérieur 19 qui s'étend perpendiculairement par rapport à une face principale plane du capot supérieur 19.

Les nervures 13 supportées par la face arrière 1c du boîtier 1 sont ici portées par cette portion arrière 18 du capot 19.

L'invention n'est pas limitée aux exemples décrits précédemment et elle englobe toute variante entrant dans le cadre défini par les revendications.

Il est à noter que certains avantages du caisson existent indépendamment du fait que le caisson contienne ou non un amplificateur audio ou indépendamment du nombre de haut-parleurs qu'il contient.

Ainsi, un autre aspect de l'invention peut aussi porter sur un caisson comportant une face inférieure s'étendant principalement dans un plan de fond de caisson et comportant :
- une portion plane de la face avant de la paroi du caisson sur laquelle est fixé un haut-parleur frontal formant un angle avec le plan de fond de caisson, mesuré à l'intérieur du caisson, qui est soit de 90°, soit compris entre 50 et 88° d'angle ; et/ou
- une portion plane de la face latérale droite de la paroi du caisson sur laquelle est fixé un haut-parleur droit formant un angle avec le plan de fond de caisson, mesuré à l'intérieur du caisson, qui est compris entre 50 et 88° d'angle ; et/ou
   - une portion plane de la face latérale gauche de la paroi du caisson sur laquelle est fixé un haut-parleur gauche formant un angle avec le plan de fond de caisson, mesuré à l'intérieur du caisson, qui est compris entre 50 et 88° d'angle.

Comme expliqué ci-avant, ce mode de réalisation permet une diffusion vers le haut des sons pour orienter le son vers un niveau supérieur au caisson où est situé la tête de l'utilisateur.

De même on fait préférentiellement en sorte que chaque paroi latérale donnée du boîtier dans lequel se trouve le caisson soit parallèle à un plan principal défini par un desdits haut-parleurs porté par le caisson en regard avec cette paroi latérale donnée du boîtier.

Ce mode de réalisation est avantageux pour limiter la distorsion de son diffusé par les haut-parleurs au travers de perforations pratiquées dans la paroi du boitier.

Tout autre placement et/ou angle des parois du caisson décrites précédemment est possible, indépendamment du fait que le caisson contienne ou non un amplificateur audio ou indépendamment du nombre de haut-parleurs qu'il contient.

## Revendications

1. Equipement (0) comportant un boîtier (1) dans lequel se trouvent :
- un caisson (2) ;
- un premier haut-parleur (3a) disposé à l'intérieur du caisson (2) et monté au niveau d'une paroi (2a) du caisson (2), le premier haut-parleur (3a) étant agencé pour diffuser des sons vers l'extérieur du boîtier (1) ;
- une carte électronique principale (4) placée dans le boîtier (1) en dehors du caisson (2) et sur laquelle est monté au moins un module d'alimentation (41) agencé pour produire une première tension d'alimentation ;
- un dispositif de connexion (5) traversant la paroi du caisson (2a) ;
- une carte électronique secondaire (6) placée à l'intérieur du caisson (2) et sur laquelle est monté au moins un premier amplificateur (6a) connecté au premier haut-parleur (3a), la carte électronique secondaire (6) étant connectée électriquement à la carte électronique principale (4) via le dispositif de connexion (5), de sorte que le premier amplificateur (6a) est alimenté par la première tension d'alimentation, **caractérisé en ce que** le dispositif de connexion (5) comporte une carte intermédiaire (5) portant une première pluralité de conducteurs électriques (50) pour alimenter le premier amplificateur (6a) avec la première tension d'alimentation, la carte intermédiaire (5) et les conducteurs électriques (50) de ladite première pluralité de conducteurs électriques passant au travers d'une ouverture (20) formée au travers de la paroi du caisson (2).

2. Equipement (0) selon la revendication 1, dans lequel la carte électronique principale (4) porte un premier connecteur mécanique (40) et la carte électronique secondaire (6) porte un second connecteur mécanique (60), la carte intermédiaire (5) portant d'une part un premier connecteur mécanique (51) de la carte intermédiaire (5) connecté de manière amovible au premier connecteur mécanique (40) porté par la carte électronique principale (4) et portant d'autre part un second connecteur mécanique (52) de la carte intermédiaire (5) connecté de manière amovible au second connecteur mécanique (60) porté par la carte électronique secondaire (6) de sorte que la première tension d'alimentation soit transmise au premier amplificateur (6a) par l'intermédiaire du premier connecteur mécanique (40) porté par la carte électronique principale (4), des premier et second connecteurs mécaniques portés par la carte intermédiaire (5) et par le second connecteur mécanique (60) porté par la carte électronique secondaire (6).

3. Equipement (0) selon la revendication 2, dans lequel :
- l'un desdits premiers connecteurs mécaniques (51) est un connecteur de type mâle emboîté dans l'autre desdits premiers connecteurs mécaniques (40) qui est un connecteur de type femelle, ces premiers connecteurs mécaniques (40, 51) étant connectés entre eux de sorte à présenter un premier jeu autorisant un mouvement relatif entre ces premiers connecteurs mécaniques (40, 51); de même
- l'un desdits seconds connecteurs mécaniques (52) est un connecteur de type mâle emboîté dans l'autre desdits seconds connecteurs mécaniques (60) qui est un connecteur de type femelle, ces seconds connecteurs mécaniques (52, 60) étant connectés entre eux de sorte à présenter un second jeu autorisant un mouvement relatif entre ces seconds connecteurs mécaniques (52, 60).

4. Equipement (0) selon l'une quelconque des revendications 2 ou 3, dans lequel la carte intermédiaire (5) s'étend en longueur et en largeur dans un plan de la carte intermédiaire (5) qui est d'une part perpendiculaire à un plan principal de la carte principale (4) et d'autre part perpendiculaire à une face avant (1b) du boîtier (1).

5. Equipement (0) selon l'une quelconque des revendications 2 à 4, dans lequel les premier et second connecteurs mécaniques (51, 52) portés par la carte intermédiaire (5) sont identiques entre eux et les premier et second connecteurs mécaniques (40, 60) respectivement portés par la carte électronique principale (4) et par la carte électronique secondaire (6) sont également identiques entre eux.

6. Equipement (0) selon l'une quelconque des revendications 1 à 5, dans lequel la carte intermédiaire (5) est de forme dissymétrique de sorte que la connexion électrique entre la carte électronique principale (4) et la carte électronique secondaire (6) via la première pluralité de conducteurs électrique (50) portés par carte intermédiaire (5) est possible dans une unique position de la carte intermédiaire (5) par rapport aux cartes électroniques principale (4) et secondaire (6) .

7. Equipement (0) selon l'une quelconque des revendications 1 à 6, dans lequel un joint compressible (7) est disposé pour s'opposer au passage d'air entre l'intérieur et l'extérieur du caisson via l'ouverture (20) formée au travers de la paroi du caisson (2).

8. Equipement (0) selon l'une quelconque des revendications 1 à 7, dans lequel un élément élastiquement déformable (8), préférentiellement en mousse, s'étend tout autour d'une portion longitudinale de la carte intermédiaire (5), à l'intérieur de l'ouverture (20) formée au travers de la paroi (2a) du caisson (2), pour s'opposer au contact entre la carte intermédiaire (5) et la paroi du caisson (2).

9. Equipement (0) selon l'une quelconque des revendications 1 à 8, comportant en outre un module audio (42) placé dans le boîtier (1) en dehors du caisson (2) et agencé pour produire un signal audio primaire, le module audio (42) étant connecté à la carte électronique secondaire (6) de sorte que lorsque le signal audio primaire est appliqué en entrée du premier amplificateur (6a) et que le premier amplificateur (6a) est alimenté par ladite première tension, le premier amplificateur (6a) produise un premier signal audio amplifié à destination du premier haut-parleur (3a).

10. Equipement (0) selon la revendication 9, dans lequel le module audio (42) est électriquement connecté à la carte électronique secondaire (6) par l'intermédiaire du dispositif de connexion (5) de sorte que le signal audio primaire soit transmis du module audio (42) au premier amplificateur (6a) par l'intermédiaire du dispositif de connexion (5).

11. Equipement (0) selon l'une quelconque des revendications 9 ou 10, dans lequel le module audio (42) est monté sur la carte électronique principale (4).

12. Equipement (0) selon l'une quelconque des revendications 1 à 11, comportant en outre :
- un haut-parleur droit (3d) disposé dans une chambre intérieure droite (20d) du caisson (2) ouverte sur une face latérale droite (2d) de la paroi du caisson (2) ;
- un haut-parleur gauche (3e) disposé dans une chambre intérieure gauche (20e) du caisson (2) ouverte sur une face latérale gauche (2e) de la paroi du caisson (2) ; et éventuellement
- un haut-parleur frontal (3b) disposé dans une chambre intérieure frontale (20b) du caisson (2) ouverte sur une face avant (2b) de la paroi du caisson (2) ;
ledit premier haut-parleur (3a) étant un haut-parleur de type haut-parleur de graves disposé dans une chambre intérieure centrale (20a) du caisson (2) disposée entre les chambres intérieures droite et gauche (20d, 20e) du caisson (2), la chambre intérieure centrale (20a) du caisson étant ouverte sur une face supérieure (2a) du caisson, les chambres intérieures droites, gauche, frontale et centrale (20a, 20b, 20d, 20e) du caisson étant étanches les unes par rapport aux autres et dans lequel le haut-parleur droit (3d) présente un axe sonore principal qui lui est propre et suivant lequel sont majoritairement diffusés les sons qu'il génère ;
- le haut-parleur gauche (3e) présente un axe sonore principal qui lui est propre et suivant lequel sont majoritairement diffusés les sons qu'il génère ;
- le haut-parleur frontal (3b) présente un axe sonore principal (Ax) qui lui est propre et suivant lequel sont majoritairement diffusés les sons qu'il génère ;
- le boîtier (1) comportant un fond de boitier (1f) définissant un plan d'appui (Px) du boitier ; et
l'un au moins desdits axes sonores principaux des haut-parleurs droit, gauche et frontal est orienté par rapport au plan d'appui (Px) de sorte que le son majoritairement diffusé suivant ledit au moins un axe sonore (Ax) s'écarte progressivement dudit plan d'appui (Px).

13. Equipement (0) selon la revendication 12, dans lequel l'axe sonore principal (Ax) du haut-parleur frontal (3b) s'étend dans un plan perpendiculaire au plan d'appui (Px) où il forme un angle frontal (A) par rapport au plan d'appui (Px) compris entre 2 et 40° d'angle, préférentiellement 3° d'angle.

14. Equipement selon l'une quelconque des revendications 1 à 13, dans lequel la carte secondaire porte au moins un condensateur de réserve d'énergie (6d) alimenté électriquement par le module d'alimentation (41) via le dispositif de connexion (5) traversant la paroi (2a) du caisson (2), ledit au moins un condensateur (6d) étant par ailleurs électriquement relié audit au moins un premier amplificateur (6a) de manière à fournir de l'énergie audit au moins un premier amplificateur.

15. Equipement selon l'une quelconque des revendications 1 à 14, dans lequel une pluralité de microphones (14a, 14b, 14c, 14d) est disposée à l'intérieur du boitier et est connectée à la carte électronique principale (4) par l'intermédiaire d'une unique connectique microphone pour d'une part alimenter électriquement cette pluralité de microphones et pour d'autre part transmettre à un module microphone porté par la carte électronique principale (4) des signaux micro représentatifs de sons captés par les microphones, une première paire des microphones (14a, 14b) étant montée sur une même première nappe de conducteurs électriques (15) et une seconde paire des microphones (14c, 14d) étant montée sur une même seconde nappe de conducteurs électriques (16), la seconde nappe (16) étant reliée électriquement à ladite première nappe (15), la première nappe s'étendant suivant un axe de première nappe et la seconde nappe s'étendant suivant un axe de seconde nappe orienté à 90° par rapport à l'axe de première nappe.

16. Equipement selon la revendication 15, dans lequel la seconde nappe (16) est reliée de manière amovible à la première nappe (15).

## Patentansprüche

1. Ausrüstung (0) enthaltend ein Gehäuse (1), in welchem sich Folgendes befindet:
- ein Korpus (2);
- ein erster Lautsprecher (3a), der im Inneren des Korpus (2) angeordnet und an einer Wand (2a) des Korpus (2) angebracht ist, wobei der erste Lautsprecher (3a) derart angeordnet ist, dass er Töne von dem Gehäuse (1) nach außen hin abgibt;
- eine Haupt-Elektronikkarte (4), die in dem Gehäuse (1) außerhalb des Korpus (2) angeordnet ist und auf welcher zumindest ein Stromversorgungsmodul (41) aufmontiert ist, das derart beschaffen ist, dass es eine erste Versorgungsspannung erzeugt;
- eine Verbindungsvorrichtung (5), welche sich durch die Korpuswand (2a) hindurch erstreckt;
- eine sekundäre Elektronikkarte (6), die im Inneren des Korpus (2) angeordnet ist und auf welcher zumindest ein erster Verstärker (6a) montiert ist, der mit dem ersten Lautsprecher (3a) verbunden ist, wobei die sekundäre Elektronikkarte (6) über die Verbindungsvorrichtung (5) derart mit der Haupt-Elektronikkarte (4) elektrisch verbunden ist, dass der erste Verstärker (6a) mit der ersten Versorgungsspannung versorgt wird, **dadurch gekennzeichnet, dass** die Verbindungsvorrichtung (5) eine Zwischenkarte (5) mit einer ersten Mehrzahl von elektrischen Leitern (50) enthält, um den ersten Verstärker (6a) mit der ersten Versorgungsspannung zu versorgen, wobei die Zwischenkarte (5) und die elektrischen Leiter (50) aus der ersten Mehrzahl von elektrischen Leitern durch eine in der Wand des Korpus (2) ausgebildete Öffnung (20) hindurchgeführt sind.

2. Ausrüstung (0) nach Anspruch 1, wobei die Haupt-Elektronikkarte (4) einen ersten mechanischen Verbinder (40) trägt und die sekundäre Elektronikkarte (6) einen zweiten mechanischen Verbinder (60) trägt, wobei die Zwischenkarte (5) einerseits einen ersten mechanischen Verbinder (51) der Zwischenkarte (5) trägt, der mit dem ersten, von der Haupt-Elektronikkarte (4) getragenen mechanischen Verbinder (40) lösbar verbunden ist, und andererseits einen zweiten mechanischen Verbinder (52) der Zwischenkarte (5) trägt, der mit dem zweiten, von der sekundären Elektronikkarte (6) getragenen mechanischen Verbinder (60) lösbar verbunden ist, sodass die erste Versorgungsspannung über den ersten, von der Haupt-Elektronikkarte (4) getragenen mechanischen Verbinder (40), über den ersten und den zweiten, von der Zwischenkarte (5) getragenen mechanischen Verbinder, und über den zweiten, von der sekundären Elektronikkarte (6) getragenen mechanischen Verbinder (60) an den ersten Verstärker (6a) übertragen wird.

3. Ausrüstung (0) nach Anspruch 2, wobei:
- es sich bei einem von den ersten mechanischen Verbindern, nämlich dem Verbinder (51), um einen Steckverbinder handelt, der in den anderen von den ersten mechanischen Verbindern, nämlich den Verbinder (40), bei dem es sich um einen Buchsenverbinder handelt, eingesteckt ist, wobei die beiden ersten mechanischen Verbinder (40, 51) derart miteinander verbunden sind, dass sie ein erstes Spiel aufweisen, welches eine Relativbewegung zwischen diesen ersten mechanischen Verbindern (40, 51) ermöglicht; und
- es sich bei einem von den zweiten mechanischen Verbindern, nämlich dem Verbinder (52), ebenfalls um einen Steckverbinder handelt, der in den anderen von den zweiten mechanischen Verbindern, nämlich den Verbinder (60), bei dem es sich um einen Buchsenverbinder handelt, eingesteckt ist, wobei die beiden zweiten mechanischen Verbinder (52, 60) derart miteinander verbunden sind, dass sie ein zweites Spiel aufweisen, welches eine Relativbewegung zwischen diesen zweiten mechanischen Verbindern (52, 60) ermöglicht.

4. Ausrüstung (0) nach einem der Ansprüche 2 oder 3, wobei sich die Zwischenkarte (5) in der Länge und in der Breite in einer Ebene der Zwischenkarte (5) erstreckt, die einerseits senkrecht zu einer Hauptebene der Haupt-Elektronikkarte (4) und andererseits senkrecht zu einer Vorderseite (1b) des Gehäuses (1) liegt.

5. Ausrüstung (0) nach einem der Ansprüche 2 bis 4, wobei der erste und der zweite mechanische Verbinder (51, 52), die von der Zwischenkarte (5) getragen werden, untereinander identisch sind und wobei der erste und der zweite mechanische Verbinder (40, 60), die jeweils von der Haupt-Elektronikkarte (4) bzw. von der sekundären Elektronikkarte (6) getragen werden, ebenfalls untereinander identisch sind.

6. Ausrüstung (0) nach einem der Ansprüche 1 bis 5, wobei die Zwischenkarte (5) unsymmetrisch ausgestaltet ist, sodass die elektrische Verbindung zwischen der Haupt-Elektronikkarte (4) und der sekundären Elektronikkarte (6) über die erste Mehrzahl von elektrischen Leitern (50), die von der Zwischenkarte (5) getragen werden, in nur einer Position der Zwischenkarte (5) in Bezug auf die Haupt-Elektronikkarte (4) und die sekundäre Elektronikkarte (6) erfolgen kann.

7. Ausrüstung (0) nach einem der Ansprüche 1 bis 6, wobei eine komprimierbare Dichtung (7) derart angeordnet ist, dass sie ein Hindurchtreten von Luft zwischen dem Korpusinneren und dem Außenbereich des Korpus über die durch die Wand des Korpus (2) hindurch ausgebildete Öffnung (20) unterbindet.

8. Ausrüstung (0) nach einem der Ansprüche 1 bis 7, wobei sich ein vorzugsweise aus Schaumstoff bestehendes, elastisch verformbares Element (8) im Inneren der durch die Wand (2a) des Korpus (2) hindurch ausgebildeten Öffnung (20) zur Gänze um einen Längsabschnitt der Zwischenkarte (5) herum erstreckt, um den Kontakt zwischen der Zwischenkarte (5) und der Wand des Korpus (2) zu unterbinden.

9. Ausrüstung (0) nach einem der Ansprüche 1 bis 8, ferner enthaltend ein Audiomodul (42), das außerhalb des Korpus (2) in dem Gehäuse (1) angeordnet und dazu eingerichtet ist, ein primäres Audiosignal zu erzeugen, wobei das Audiomodul (42) derart mit der sekundären Elektronikkarte (6) verbunden ist, dass, wenn das primäre Audiosignal an den Eingang des ersten Verstärkers (6a) angelegt wird und der erste Verstärker (6a) mit der ersten Spannung versorgt wird, der erste Verstärker (6a) ein erstes, verstärktes Audiosignal zur Bereitstellung an den ersten Lautsprecher (3a) erzeugt.

10. Ausrüstung (0) nach Anspruch 9, wobei das Audiomodul (42) über die Verbindungsvorrichtung (5) derart mit der sekundären Elektronikkarte (6) elektrisch verbunden ist, dass das primäre Audiosignal von dem Audiomodul (42) über die Verbindungsvorrichtung (5) an den ersten Verstärker (6a) übertragen wird.

11. Ausrüstung (0) nach einem der Ansprüche 9 oder 10, wobei das Audiomodul (42) auf der Haupt-Elektronikkarte (4) aufmontiert ist.

12. Vorrichtung (0) nach einem der Ansprüche 1 bis 11, ferner enthaltend:
- einen rechten Lautsprecher (3d), der in einer rechten Innenkammer (20d) des Korpus (2) angeordnet ist, welche zu einer rechten Seitenfläche (2d) der Wand des Korpus (2) hin offen ist;
- einen linken Lautsprecher (3e), der in einer linken Innenkammer (20e) des Korpus (2) angeordnet ist, welche zu einer linken Seitenfläche (2e) der Wand des Korpus (2) hin offen ist; und gegebenenfalls
- einen stirnseitigen Lautsprecher (3b), der in einer stirnseitigen Innenkammer (20b) des Korpus (2) angeordnet ist, welche zu einer Vorderseite (2b) der Wand des Gehäuses (2) hin offen ist;
wobei es sich bei dem ersten Lautsprecher (3a) der Art nach um einen Tieftonlautsprecher handelt, der in einer mittleren, zwischen der rechten und der linken Innenkammer (20d, 20e) des Korpus (2) angeordneten Innenkammer (20a) des Korpus (2) angeordnet ist, wobei die mittlere Innenkammer (20a) des Korpus zu einer Oberseite (2a) des Korpus hin offen ist, wobei die rechte, die linke, die stirnseitige und die mittlere Innenkammer (20a, 20b, 20d, 20e) des Korpus gegeneinander abgedichtet sind, und wobei der rechte Lautsprecher (3d) eine ihm eigene Hauptschallachse aufweist, entlang derer die von ihm erzeugten Töne überwiegend abgegeben werden;
- wobei der linke Lautsprecher (3e) eine ihm eigene Hauptschallachse aufweist, entlang derer die von ihm erzeugten Töne überwiegend abgegeben werden;
- wobei der stirnseitige Lautsprecher (3b) eine ihm eigene Hauptschallachse (Ax) aufweist, entlang derer die von ihm erzeugten Töne überwiegend abgegeben werden;
- wobei das Gehäuse (1) einen Gehäuseboden (1f) enthält, der eine Auflageebene (Px) des Gehäuses definiert; und
wobei zumindest eine von den Hauptschallachsen des rechten, des linken und des stirnseitigen Lautsprechers in Bezug auf die Auflageebene (Px) derart ausgerichtet ist, dass sich der überwiegend entlang der zumindest einen Schallachse (Ax) abgegebene Ton zunehmend von der Auflageebene (Px) entfernt.

13. Ausrüstung (0) nach Anspruch 12, wobei sich die Hauptschallachse (Ax) des stirnseitigen Lautsprechers (3b) in einer Ebene senkrecht zu der Auflageebene (Px) erstreckt, auf welcher sie einen stirnseitigen Winkel (A) von 2 bis 40 Winkelgraden, vorzugsweise von 3 Winkelgraden, in Bezug auf die Auflageebene (Px) bildet.

14. Ausrüstung nach einem der Ansprüche 1 bis 13, wobei die sekundäre Elektronikkarte zumindest einen Energiereservekondensator (6d) trägt, der von dem Versorgungsmodul (41) über die durch die Wand (2a) des Korpus (2) hindurchgehende Verbindungsvorrichtung (5) mit Strom versorgt wird, wobei der zumindest eine Kondensator (6d) außerdem mit dem zumindest einen ersten Verstärker (6a) elektrisch verbunden ist, um den zumindest einen ersten Verstärker mit Energie zu versorgen.

15. Ausrüstung nach einem der Ansprüche 1 bis 14, wobei eine Mehrzahl von Mikrofonen (14a, 14b, 14c, 14d) innerhalb des Gehäuses angeordnet ist und über nur einen Mikrofonanschluss derart mit der Haupt-Elektronikkarte (4) verbunden ist, dass diese einerseits die Mehrzahl von Mikrofonen mit Strom versorgt und andererseits Mikrofonsignale an ein von der Haupt-Elektronikkarte (4) getragenes Mikrofonmodul sendet, welche Töne darstellen, die von den Mikrofonen aufgenommen worden sind, wobei ein erstes Paar von Mikrofonen (14a, 14b) auf ein und derselben ersten Bahn elektrischer Leiter (15) montiert ist und ein zweites Paar von Mikrofonen (14c, 14d) auf ein und derselben zweiten Bahn elektrischer Leiter (16) montiert ist, wobei die zweite Bahn (16) mit der ersten Bahn (15) elektrisch verbunden ist, wobei sich die erste Bahn entlang einer Achse der ersten Bahn erstreckt und wobei sich die zweite Bahn entlang einer Achse der zweiten Bahn erstreckt, die in einem Winkel von 90° in Bezug auf die Achse der ersten Bahn ausgerichtet ist.

16. Ausrüstung nach Anspruch 15, wobei die zweite Bahn (16) mit der ersten Bahn (15) lösbar verbunden ist.

## Claims

1. Equipment (0) comprising a casing (1), wherein are located:
- a box (2);
- a first loudspeaker (3a) disposed inside the box (2) and mounted at a wall (2a) of the box (2), the first loudspeaker (3a) being arranged to broadcast sounds outwards from the casing (1);
- a main electronic board (4) placed in the casing (1) outside of the box (2) and on which is mounted at least one power supply module (41) arranged to produce a first power supply voltage;
- a connecting device (5) passing through the wall of the box (2a);
- a secondary electronic board (6) placed inside the box (2) and on which is mounted at least one first amplifier (6a) connected to the first loudspeaker (3a), the secondary electronic board (6) being electrically connected to the main electronic board (4) via the connecting device (5), such that the first amplifier (6a) is powered by the first power supply voltage, **characterised in that** the connecting device (5) comprises an intermediate board (5) carrying a first plurality of electrical conductors (50) to power the first amplifier (6a) with the first power supply voltage, the intermediate board (5) and the electrical conductors (50) of said first plurality of electrical conductors passing through an opening (20) formed through the wall of the box (2) .

2. Equipment (0) according to claim 1, wherein the main electronic board (4) carries a first mechanical connector (40) and the secondary electronic board (6) carries a second mechanical connector (60), the intermediate board (5) carrying, on the one hand, a first mechanical connector (51) of the intermediate board (5) removably connected to the first mechanical connector (40) carried by the main electronic board (4) and carrying, on the other hand, a second mechanical connector (52) of the intermediate board (5) removably connected to the second mechanical connector (60) carried by the secondary electronic board (6), such that the first power supply voltage is transmitted to the first amplifier (6a) by way of the first mechanical connector (40) carried by the main electronic board (4), first and second mechanical connectors carried by the intermediate board (5) and by the second mechanical connector (60) carried by the secondary electronic board (6).

3. Equipment (0) according to claim 2, wherein:
- one of said first mechanical connectors (51) is a male-type connector interlocked in the other of said first mechanical connectors (40) which is a female-type connector, these first mechanical connectors (40, 51) being connected to one another, so as to have a first clearance enabling a relative movement between these first mechanical connectors (40, 51), likewise
- one of said second mechanical connectors (52) is a male-type connector interlocked in the other of said second mechanical connectors (60) which is a female-type connector, these second mechanical connectors (52, 60) being connected to one another, so as to have a second clearance enabling a relative movement between these second mechanical connectors (52, 60).

4. Equipment (0) according to any one of claims 2 or 3, wherein the intermediate board (5) extends in length and in width into a plane of the intermediate board (5), which is on the one hand, perpendicular to a main plane of the main board (4), and on the other hand, perpendicular to a front face (1b) of the casing (1).

5. Equipment (0) according to any one of claims 2 to 4, wherein the first and second mechanical connectors (51, 52) carried by the intermediate board (5) are identical to one another and the first and second mechanical connectors (40, 60) respectively carried by the main electronic board (4) and by the secondary electronic board (6) are also identical to one another.

6. Equipment (0) according to any one of claims 1 to 5, wherein the intermediate board (5) is of asymmetric form, such that the electrical connection between the main electronic board (4) and the secondary electronic board (6) via the first plurality of electrical conductors (50) carried by the intermediate board (5) is possible in one single position of the intermediate board (5) with respect to the main (4) and secondary (6) electronic boards.

7. Equipment (0) according to any one of claims 1 to 6, wherein a compressible seal (7) is disposed to oppose the air passage between the inside and the outside of the box via the opening (20) formed through the wall of the box (2).

8. Equipment (0) according to any one of claims 1 to 7, wherein an elastically deformable element (8), preferably made of foam, extends all around a longitudinal portion of the intermediate board (5), inside the opening (20) formed through the wall (2a) of the box (2), to oppose the contact between the intermediate board (5) and the wall of the box (2) .

9. Equipment (0) according to any one of claims 1 to 8, further comprising an audio module (42) placed in the casing (1) outside of the box (2) and arranged to produce a primary audio signal, the audio module (42) being connected to the secondary electronic board (6), such that when the primary audio signal is applied at the input of the first amplifier (6a) and that the first amplifier (6a) is powered by said first voltage, the first amplifier (6a) produces a first amplified audio signal sent to the first loudspeaker (3a).

10. Equipment (0) according to claim 9, wherein the audio module (42) is electrically connected to the secondary electronic board (6) by way of the connecting device (5), such that the primary audio signal is transmitted from the audio module (42) to the first amplifier (6a) by way of the connecting device (5).

11. Equipment (0) according to any one of claims 9 or 10, wherein the audio module (42) is mounted on the main electronic board (4).

12. Equipment (0) according to any one of claims 1 to 11, further comprising:
- a right loudspeaker (3d) disposed in a right inner chamber (20d) of the box (2) open on a right side face (2d) of the wall of the box (2);
- a left loudspeaker (3e) disposed in a left inner chamber (20e) of the box (2) open on a left side face (2e) of the wall of the box (2); and optionally
- a front loudspeaker (3b) disposed in a front inner chamber (20b) of the box (2) open on a front face (2b) of the wall of the box (2);
said first loudspeaker (3a) being a woofer-type loudspeaker disposed in a central inner chamber (20a) of the box (2) disposed between the right and left inner chambers (20d, 20e) of the box (2), the central inner chamber (20a) of the box being open on an upper face (2a) of the box, the right, left, front and central inner chambers (20a, 20b, 20d, 20e) of the box being sealed against one another and wherein the right loudspeaker (3d) has a main sound axis which is specific to it, and along which the sounds that it generates are mainly broadcast;
- the left loudspeaker (3e) has a main sound axis which is specific to it, and along which the sounds that it generates are mainly broadcast;
- the front loudspeaker (3b) has a main sound axis (Ax) which is specific to it, and along which the sounds that it generates are mainly broadcast;
- the casing (1) comprising the casing bottom (1f) defining a support plane (Px) of the casing; and
at least one of said main sound axes of the right, left and front loudspeakers is oriented with respect to the support plane (Px), such that the sound mainly broadcast along said at least one sound axis (Ax) moves progressively away from said support plane (Px).

13. Equipment (0) according to claim 12, wherein the main sound axis (Ax) of the front loudspeaker (3b) extends into a plane perpendicular to the support plane (Px) where it forms a front angle (A) with respect to the support plane (Px) which is of between 2 and 40° of angle, preferably of 3° of angle.

14. Equipment according to any one of claims 1 to 13, wherein the secondary board carries at least one energy reserve capacitor (6d) electrically powered by the power supply module (41) via the connecting device (5) passing through the wall (2a) of the box (2), said at least one capacitor (6d) being moreover electrically connected to said at least one first amplifier (6a), so as to supply energy to said at least one first amplifier.

15. Equipment according to any one of claims 1 to 14, wherein a plurality of microphones (14a, 14b, 14c, 14d) is disposed inside the casing and is connected to the main electronic board (4) by way of one single microphone connector to, on the one hand, electrically power this plurality of microphones and to, on the other hand, transmit to a microphone module carried by the main electronic board (4), micro signals representative of sounds captured by the microphones, a first pair of microphones (14a, 14b) being mounted on one same first layer of electrical conductors (15) and a second pair of microphones (14c, 14d) being mounted on one same second layer of electrical conductors (16), the second layer (16) being electrically connected to said first layer (15), the first layer extending along a first axis layer and the second layer extending along a second axis layer oriented at 90° with respect to the first layer axis.

16. Equipment according to claim 15, wherein the second layer (16) is removably connected to the first layer (15).
